# EUROPEAN PATENT APPLICATION

(11) **EP 3 493 392 A1**
(43) Date of publication of application: **05.06.2019**
(21) Application number: 18209773.3
(22) Date of filing: 03.12.2018
(51) Int. Cl.: H02M 7/5387, H05K 7/20, B62D 5/04

(54) **INVERTER DEVICE**

(30) Priority: 04.12.2017 JP 2017232921
(71) Applicant: JTEKT CORPORATION, Osaka 542-8502 (JP)
(72) Inventor: KOUCHI, Tatsuma, Osaka-shi,, Osaka 542-8502 (JP)
(74) Representative: Winter, Brandl, Fürniss, Hübner, Röss, Kaiser, Polte - Partnerschaft mbB

(57) **Abstract**

An inverter device includes a radiator that includes a latent heat storage material transitioning between a solid phase region, a phase transition region, and a liquid phase region, in accordance with a temperature of the latent heat storage material, and that absorbs heat generated in switching elements, a temperature sensor that detects the temperature of the latent heat storage material, and a microcomputer. The microcomputer includes a determining unit that determines whether a condition is satisfied, the condition being that the temperature of the latent heat storage material is close to a melting point of the latent heat storage material, and that the temperature of the latent heat storage material is on a rising trend, and a supercooling suppressing unit that limits a motor current when the determining unit determines that the condition is satisfied.

## Description

### BACKGROUND OF THE INVENTION

### 1. Field of the Invention

The present invention relates to an inverter device.

### 2. Description of Related Art

Japanese Patent Application Publication No. 2012-99612 (JP 2012-99612 A) discloses a semiconductor device including a latent heat storage material that absorbs the heat generated in a semiconductor element (switching element). The latent heat storage material transitions between a solid phase region corresponding to a solid state, a phase transition region where a solid state and a liquid state co-exist, and a liquid phase region corresponding to a liquid state, in accordance with the temperature thereof. The latent heat storage material absorbs heat energy when transitioning from the solid state to the liquid state, and releases heat energy when transitioning from the liquid state to the solid state. In the semiconductor device disclosed in JP2012-99612 A, the latent heat storage material having such physical properties is used to control the temperature of the semiconductor element.

However, the latent heat storage material has a problem with supercooling. Supercooling is a phenomenon in which, in the case where the temperature of the latent heat storage material is in the liquid phase region, even when the temperature of the latent heat storage material is lowered below its freezing point, the latent heat storage material is not recrystallized and is maintained in the liquid state although the temperature is supposed to be located in the solid phase region. When the latent heat storage material is supercooled, the temperature of the switching element cannot be appropriately controlled.

### SUMMARY OF THE INVENTION

An object of the present invention is to provide an inverter device capable of suppressing supercooling of a latent heat storage material, and appropriately controlling the temperature of a switching element.

An inverter device according to an aspect of the present invention includes: a motor drive circuit unit that includes a plurality of arm circuits each including a plurality of switching elements, and that converts a direct current (DC) signal supplied from a DC power supply into a motor current formed of an alternating current (AC) signal; a radiator that includes a latent heat storage material transitioning between a solid phase region corresponding to a solid state, a phase transition region where the solid state and a liquid state co-exist, and a liquid phase region corresponding to the liquid state, in accordance with a temperature of the latent heat storage material, and that absorbs heat generated in the plurality of switching elements; a temperature sensor that detects the temperature of the latent heat storage material; and a control device connected to the plurality of switching elements and the temperature sensor; wherein the control device includes a determining unit that determines whether a condition is satisfied, the condition being that the temperature of the latent heat storage material is close to a melting point of the latent heat storage material, and that the temperature of the latent heat storage material is on a rising trend, and a supercooling suppressing unit that limits the motor current when the determining unit determines that the condition is satisfied.

### BRIEF DESCRIPTION OF THE DRAWINGS

The foregoing and further features and advantages of the invention will become apparent from the following description of example embodiments with reference to the accompanying drawings, wherein like numerals are used to represent like elements and wherein:
FIG. 1 is a schematic diagram illustrating the general configuration of an electric power steering system to which an inverter device according to a first embodiment of the present invention is applied;
FIG. 2 is a block diagram schematically illustrating the electrical configuration of an ECU;
FIG. 3 is a plan view illustrating the general configuration of the inverter device;
FIG. 4 is a cross-sectional view taken along the line IV-IV of FIG. 3;
FIG. 5 is a graph illustrating the characteristics of a latent heat storage material;
FIG. 6 is a flowchart illustrating exemplary operations of a limiter control unit;
FIG. 7 is a graph illustrating the characteristics of the latent heat storage material;
FIG. 8 is a block diagram schematically illustrating the electrical configuration of an ECU to which an inverter device according to a second embodiment of the present invention is applied;
FIG. 9 is a cross-sectional view of a part corresponding to the part illustrated in FIG. 4, illustrating the general configuration of the inverter device of FIG. 8; and
FIG. 10 is a flowchart illustrating exemplary operations of a relay section control unit.

### DETAILED DESCRIPTION OF EMBODIMENTS

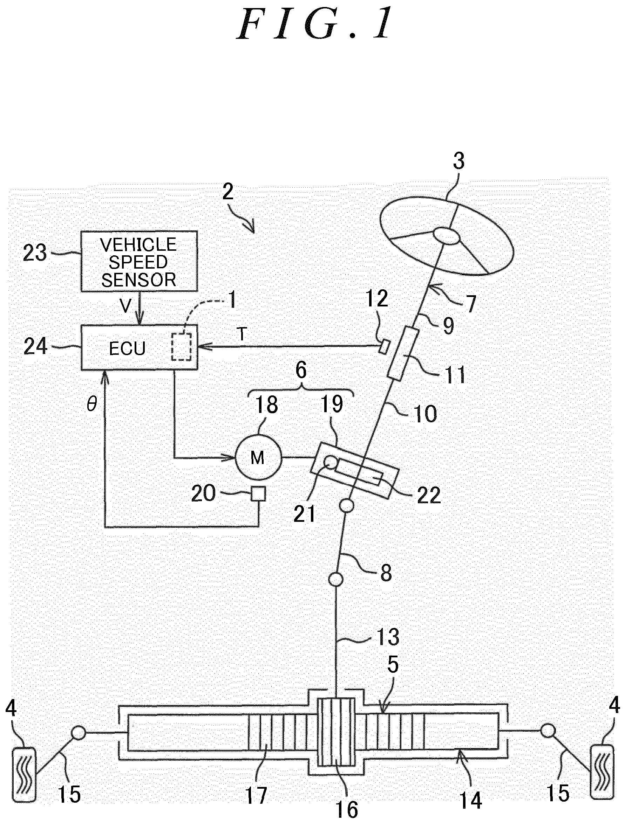

Hereinafter, exemplary embodiments of the present invention will be described in detail with reference to the accompanying drawings. In the exemplary embodiments, an inverter device is applied to an electric power steering system. FIG. 1 is a schematic diagram illustrating the general configuration of an electric power steering system 2 to which an inverter device 1 is applied according to a first embodiment of the present invention. The electric power steering system 2 includes a steering wheel 3, a steering operation mechanism 5, and a steering assist mechanism 6. The steering wheel 3 is a steering member for steering the vehicle. The steering operation mechanism 5 steers steered wheels 4 in conjunction with rotation of the steering wheel 3. The steering assist mechanism 6 assists the driver in steering.

The steering wheel 3 and the steering operation mechanism 5 are mechanically coupled to each other via a steering shaft 7 and an intermediate shaft 8. The steering shaft 7 includes an input shaft 9 coupled to the steering wheel 3, and an output shaft 10 coupled to the intermediate shaft 8. The input shaft 9 and the output shaft 10 are relatively rotatably coupled to each other via a torsion bar 11. A torque sensor 12 is disposed near the torsion bar 11. The torque sensor 12 detects a steering torque T applied to the steering wheel 3, based on the amount of relative rotational displacement between the input shaft 9 and the output shaft 10.

For example, the torque sensor 12 detects the steering torque T for steering to the right as a positive value, and detects the steering torque T for steering to the left as a negative value. The greater the absolute value of the steering torque T is, the greater the amount of steering torque T is. The steering operation mechanism 5 includes a rack-and-pinion mechanism. The rack-and-pinion mechanism includes a pinion shaft 13, and a rack shaft 14 that serves as a steered shaft. The steered wheels 4 are coupled to the opposite ends of the rack shaft 14 via tie rods 15 and knuckle arms (not illustrated).

The pinion shaft 13 is coupled to the intermediate shaft 8. The pinion shaft 13 rotates in conjunction with steering of the steering wheel 3. A pinion 16 is coupled to an end (lower end in FIG. 1) of the pinion shaft 13. The rack shaft 14 extends linearly in the lateral direction of the vehicle. A rack 17 that meshes with the pinion 16 is formed at an axially intermediate portion of the rack shaft 14.

When the steering wheel 3 is operated (rotated), the rotation is transmitted to the pinion shaft 13 via the steering shaft 7 and the intermediate shaft 8. The pinion 16 and the rack 17 convert rotation of the pinion shaft 13 into axial movement of the rack shaft 14. In this way, the steered wheels 4 are steered. The steering assist mechanism 6 includes an electric motor 18 for assisting in steering, and a speed reduction mechanism 19 that transmits an output torque of the electric motor 18 toward the steering operation mechanism 5. The electric motor 18 is a three-phase brushless motor in this embodiment.

The electric motor 18 is provided with a rotation angle sensor 20 that detects a rotation angle of the electric motor 18. The rotation angle sensor 20 may include a resolver. The speed reduction mechanism 19 includes a worm gear mechanism. The worm gear mechanism includes a worm shaft 21, and a worm wheel 22 that meshes with the worm shaft 21. The worm shaft 21 is rotationally driven by the electric motor 18.

The worm wheel 22 is coupled to the steering shaft 7 so as to be rotatable with the steering shaft 7. The worm wheel 22 is rotationally driven by the worm shaft 21. When the worm shaft 21 is rotationally driven by the electric motor 18, the worm wheel 22 is rotationally driven, and the steering shaft 7 is rotated. Then, the rotation of the steering shaft 7 is transmitted to the pinion shaft 13 via the intermediate shaft 8.

The rotation of the pinion shaft 13 is converted into axial movement of the rack shaft 14. In this way, the steered wheels 4 are steered. That is, the electric motor 18 rotationally drives the worm shaft 21, and thus can assist in steering. The vehicle is provided with a vehicle speed sensor 23 for detecting a vehicle speed V. The steering torque T detected by the torque sensor 12, the vehicle speed V detected by the vehicle speed sensor 23, signals output from the rotation angle sensor 20, and so on are input to an electrical control unit (ECU) 24. The ECU 24 controls the electric motor 18, based on these input signals.

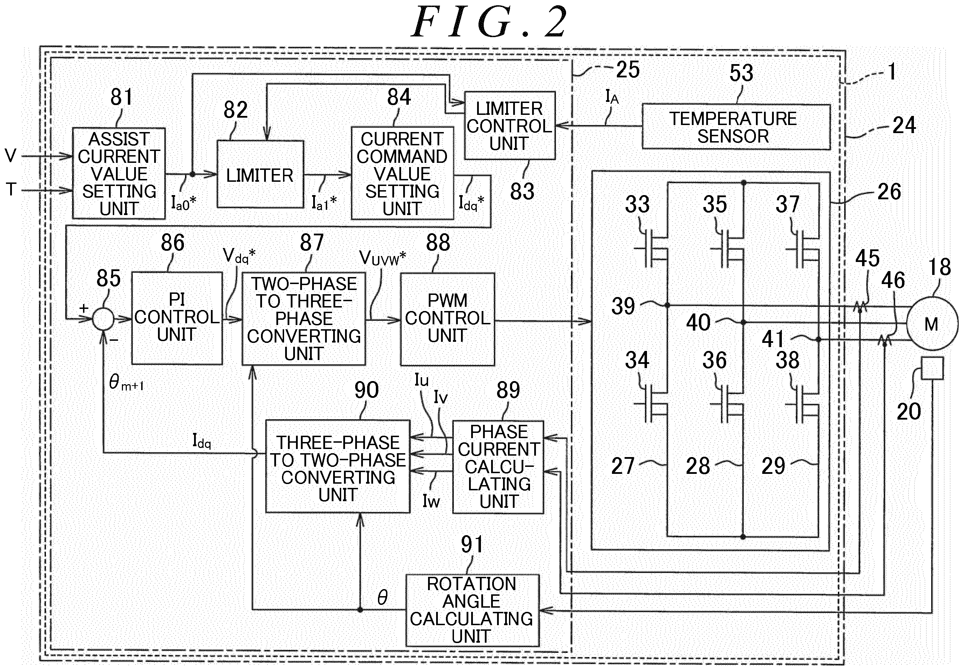

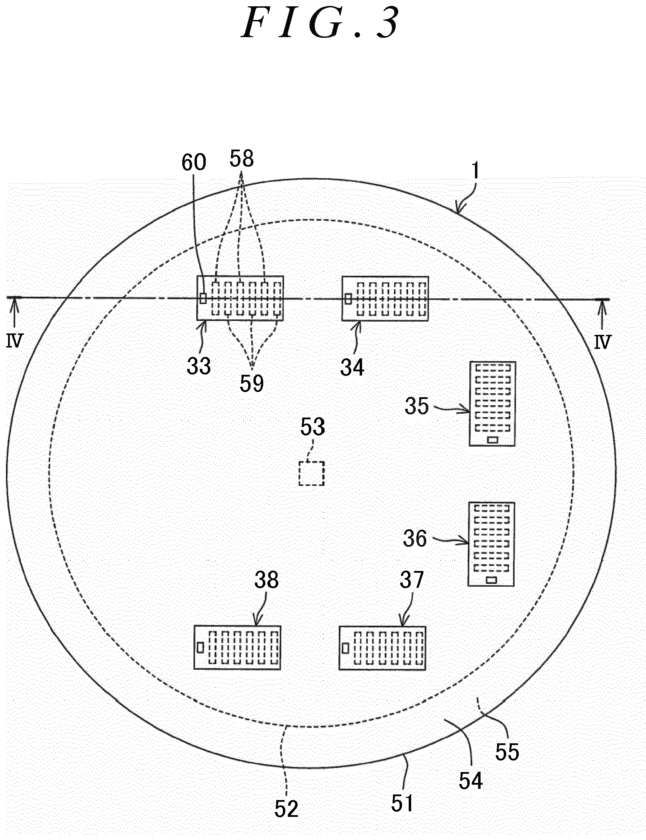

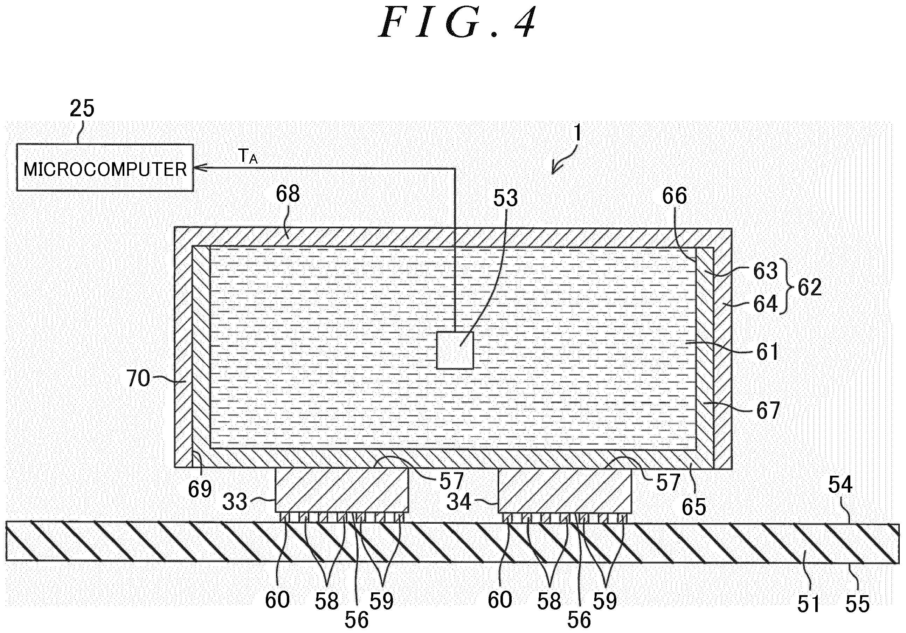

FIG. 2 is a block diagram schematically illustrating the electrical configuration of the ECU 24. FIG. 3 is a plan view illustrating the structure of the inverter device 1. FIG. 4 is a cross-sectional view taken along the line IV-IV in FIG. 3. Referring to FIG. 2, the ECU 24 includes the inverter device 1 that supplies electric power to the electric motor 18. The inverter device 1 includes a motor drive circuit unit 26 and a microcomputer 25 (control device). The motor drive circuit unit 26 converts a direct current (DC) signal supplied from a DC power supply (not illustrated) into a motor current formed of an alternating current (AC) signal. The microcomputer 25 is connected to the motor drive circuit unit 26, and controls the motor drive circuit unit 26.

The electric motor 18 includes a rotor and a stator. Although not illustrated, the stator includes a U-phase field winding, a V-phase field winding, and a W-phase field winding. The motor drive circuit unit 26 includes a U-phase arm circuit 27, a V-phase arm circuit 28, and a W-phase arm circuit 29 respectively corresponding to the U-phase field winding, the V-phase field winding, and the W-phase field winding of the electric motor 18. The U-phase arm circuit 27 includes a series circuit of a pair of switching elements 33 and 34 corresponding to a U phase of the electric motor 18. The series circuit of the pair of switching elements 33 and 34 is connected in parallel between a DC power supply and a reference voltage (for example, ground voltage). The switching element 33 is provided as an upper arm. The switching element 34 is provided as a lower arm.

The V-phase arm circuit 28 includes a series circuit of a pair of switching elements 35 and 36 corresponding to a V phase of the electric motor 18. The series circuit of the pair of switching elements 35 and 36 is connected in parallel between the DC power supply and the reference voltage. The switching element 35 is provided as an upper arm. The switching element 36 is provided as a lower arm. The W-phase arm circuit 29 includes a series circuit of a pair of switching elements 37 and 38 corresponding to a W phase of the electric motor 18. The series circuit of the pair of switching elements 37 and 38 is connected in parallel between the DC power supply and the reference voltage. The switching element 37 is provided as an upper arm. The switching element 38 is provided as a lower arm.

In this embodiment, each of the switching elements 33 to 38 includes an n-channel metal insulator semiconductor field effect transistor (MISFET). Drains of the switching elements 33, 35, and 37 of the upper arms are connected to the DC power supply. Sources of the switching elements 33, 35, and 37 of the upper arms are connected to drains of the switching elements 34, 36, and 38 of the lower arms. Sources of the switching elements 34, 36, and 38 of the lower arms are connected to the reference voltage.

A regeneration diode may be connected in parallel to each of the switching elements 33 to 38. The regeneration diode may be connected in parallel such that a forward current flows toward the drain of each of the switching elements 33 to 38. In the U-phase arm circuit 27, a U-phase connection point 39 between the paired switching elements 33 and 34 is connected to one end of the U-phase field winding of the electric motor 18 via a U-phase power supply line.

In the V-phase arm circuit 28, a V-phase connection point 40 between the paired switching elements 35 and 36 is connected to one end of the V-phase field winding of the electric motor 18 via a V-phase power supply line. In the W-phase arm circuit 29, a W-phase connection point 41 between the paired switching elements 37 and 38 is connected to one end of the W-phase field winding of the electric motor 18 via a W-phase power supply line.

The other ends of the U-phase field winding, the V-shape field winding, and the W-phase field winding of the electric motor 18 are connected to each other. The U-phase power supply line is provided with a U-phase current sensor 45. The W-phase power supply line is provided with a W-phase current sensor 46. Although not illustrated in FIG. 2, gate drive circuits for generating gate signals to the respective switching elements 33 to 38 are connected to the gates of the respective switching elements 33 to 38. Referring to FIGS. 3 and 4, the inverter device 1 includes a substrate 51, a radiator 52, and a temperature sensor 53, in addition to the motor drive circuit unit 26. In FIG. 3, the radiator 52 and the temperature sensor 53 are indicated by the dashed lines.

The substrate 51 is a circuit board with the motor drive circuit unit 26 mounted thereon, and is formed in a circular shape in plan view in this embodiment. The substrate 51 may be a ceramic substrate, a glass epoxy substrate and the like. The substrate 51 includes a first main surface 54 on one side, and a second main surface 55 on the other side. The plurality of switching elements 33 to 38, the plurality of regeneration diodes, and other elements are mounted on the first main surface 54 of the substrate 51. In FIGS. 3 and 4, the regeneration diodes and other elements are not illustrated for purposes of simplicity.

A wiring pattern for connecting the switching elements 33 to 38 may be formed on the first main surface 54 of the substrate 51. A control circuit (for example, the microcomputer 25) for controlling the switching elements 33 to 38 may be mounted on the second main surface 55 of the substrate 51. Each of the switching elements 33 to 38 is formed in the shape of a rectangular parallelepiped having a rectangular shape elongated in one direction in plan view. Each of the switching elements 33 to 38 has a mounting surface 56 on one side, and a non-mounting surface 57 on the other side.

In this embodiment, the non-mounting surface 57 is a non-electrode surface with no electrode mounted thereon. That is, each of the switching elements 33 to 38 is a so-called lateral semiconductor device. A plurality of drain electrodes 58, a plurality of source electrodes 59, and one gate electrode 60 are formed on the mounting surface 56 of each of the switching elements 33 to 38. Each of the drain electrodes 58 and the source electrodes 59 has a rectangular shape elongated in the short-side direction of the mounting surface 56 in plan view.

The plurality of drain electrodes 58 and the plurality of source electrodes 59 are alternately arranged at intervals in the long-side direction of the mounting surface 56. The gate electrode 60 has the shape of a rectangle close to a square in plan view, and is arranged at the center in the width direction on one end side of the mounting surface 56. The layout, the arrangement, and the number of drain electrodes 58, source electrodes 59, and gate electrodes 60 may be arbitrarily determined in accordance with the specifications of the switching elements 33 to 38. For example, the drain electrode 58 and the source electrode 59 may be formed in a comb teeth shape to face each other.

Each of the switching elements 33 to 38 is joined to the first main surface 54 of the substrate 51, with its mounting surface 56 facing the first main surface 54. The drain electrodes 58, the source electrodes 59, and the gate electrode 60 are connected to the wiring pattern formed on the first main surface 54 of the substrate 51 by soldering. The first switching element 33 and the second switching element 34 may be arranged in a line at intervals along the periphery of the first main surface 54 of the substrate 51 such that their long-side directions coincide in plan view.

The third switching element 35 and the fourth switching element 36 may be arranged in a line at intervals along the periphery of the first main surface 54 of the substrate 51 such that their long-side directions coincide in plan view. The fifth switching element 37 and the sixth switching element 38 may be arranged in a line at intervals along the periphery of the first main surface 54 of the substrate 51 such that their long-side directions coincide in plan view.

A pair of the first switching element 33 and the second switching element 34, a pair of the third switching element 35 and the fourth switching element 36, and a pair of the fifth switching element 37 and the sixth switching element 38 may be arranged at positions respectively corresponding to three of the four sides of the square inscribed in the periphery of the substrate 51 in plan view. The radiator 52 covers all the plurality of switching elements 33 to 38, and is connected to all the non-mounting surface 57 of the plurality of switching elements 33 to 38. The radiator 52 may be connected to the non-mounting surfaces 57 of the plurality of switching elements 33 to 38 with metallic or insulating adhesive, a radiation sheet, or thermal grease interposed therebetween.

In this embodiment, the radiator 52 may be formed in a circular shape having a diameter less than or equal to the diameter of the substrate 51 in plan view. The radiator 52 may be formed in a circular shape having a diameter greater than the diameter of the substrate 51 in plan view. The radiator 52 may be arranged concentrically with the substrate 51 in plan view. The shape of the radiator in plan view is not limited to a circular shape. The radiator 52 may be formed in a polygonal shape such as a quadrilateral in plan view.

In this embodiment, the radiator 52 includes a casing 62 with a latent heat storage material 61 sealed therein. The latent heat storage material 61 may contain at least one of erythritol, paraffin, and inorganic hydrated salt (for example, sodium acetate). More specifically, the casing 62 includes a container part 63 filled with the latent heat storage material 61, and a lid part 64 closing the container part 63. The container part 63 and the lid part 64 may contain aluminum. The container part 63 includes a plate-shaped (in this embodiment, a circular plate shaped) bottom wall 65, and a cylindrical (in this embodiment, a circular cylindrical) side wall 67. The side wall 67 extends upright from the periphery of the bottom wall 65 so as to define an opening 66 on the side opposite to the bottom wall 65.

The lid part 64 includes a plate-shaped (in this embodiment, a circular plate shaped) top wall 68, and a cylindrical (in this embodiment, a circular cylindrical) side wall 70. The side wall 70 extends downward from the periphery of the top wall 68 so as to define an opening 69 on the side opposite to the top wall 68. The lid part 64 is press-fitted to the container part 63 in a manner such that the side wall 70 is externally fitted to the side wall 67 of the container part 63. The lid part 64 may be press-fitted to the container part 63 in a manner such that the side wall 70 is internally fitted to the side wall 67 of the container part 63.

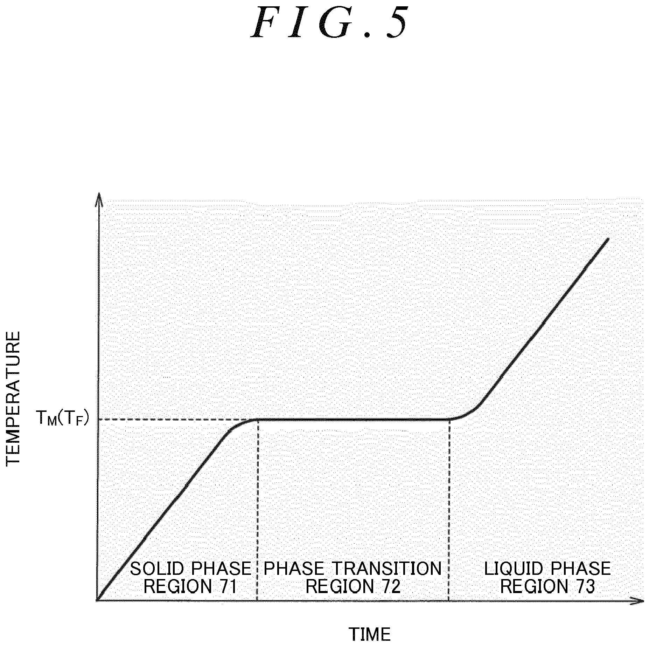

The latent heat storage material 61 fills the space defined by the bottom wall 65 and the side wall 67 of the container part 63. The properties of the latent heat storage material 61 will be described with reference to FIG. 5. FIG. 5 is a graph illustrating the properties of the latent heat storage material 61. When the temperature rise rate of the latent heat storage material 61 is greater than the natural cooling rate, a temperature T_{A} of the latent heat storage material 61 rises. On the other hand, when the natural cooling rate is greater than the temperature rise rate of the latent heat storage material 61, the temperature T_{A} of the latent heat storage material 61 drops.

The latent heat storage material 61 transitions between a solid phase region 71 corresponding to a solid state, a phase transition region 72 where a solid state and a liquid state co-exist, and a liquid phase region 73 corresponding to a liquid state, in accordance with a rise in the temperature T_{A}. In the case where the temperature T_{A} of the latent heat storage material 61 is in the solid phase region 71, when the temperature T_{A} of the latent heat storage material 61 rises to a melting point T_{M} or above (T_{A} ≥ T_{M}), the latent heat storage material 61 transitions from the solid phase region 71 to the phase transition region 72.

The latent heat storage material 61 absorbs heat energy when transitioning from the solid state to the liquid state. Therefore, when the latent heat storage material 61 is in the phase transition region 72 and is transitioning from the solid state to the liquid state, the rise in the temperature T_{A} of the latent heat storage material 61 is suppressed. Then, when the latent heat storage material 61 is completely in the liquid state, the temperature T_{A} of the latent heat storage material 61 rises again. On the other hand, in the case where the temperature T_{A} of the latent heat storage material 61 is in the liquid phase region 73, when the temperature T_{A} of the latent heat storage material 61 drops to a freezing point T_{F} or below (T_{A} ≤ T_{F}), the latent heat storage material 61 transitions from the liquid phase region 73 to the phase transition region 72. In this embodiment, for example, the melting point T_{M} and the freezing point T_{F} of the latent heat storage material 61 are substantially the same.

The latent heat storage material 61 releases heat energy when transitioning from the liquid state to the solid state. Therefore, when the latent heat storage material 61 is in the phase transition region 72 and is transitioning from the liquid state to the solid state, the drop in the temperature T_{A} of the latent heat storage material 61 is suppressed. Then, when the temperature T_{A} drops below the freezing point T_{F} (T_{A} < T_{F}) and the latent heat storage material 61 is completely in the solid state, the temperature T_{A} of the latent heat storage material 61 drops again.

The heat generated in the switching elements 33 to 38 are absorbed by the latent heat storage material 61 having the physical properties described above. The temperature sensor 53 is disposed in the casing 62 of the radiator 52, and detects the temperature T_{A} of the latent heat storage material 61. The temperature sensor 53 may be a thermocouple. The temperature sensor 53 is disposed at the center of the casing 62 in plan view. The temperature sensor 53 may be disposed at the center of gravity of the latent heat storage material 61.

A part of the latent heat storage material 61 at the center of the casing 62 (the center of gravity of the latent heat storage material 61) is located at a position away from the switching elements 33 to 38. Therefore, the part of the latent heat storage material 61 at the center of the casing 62 (the center of gravity of the latent heat storage material 61) is not easily heated, and does not easily transition from the solid state to the liquid state. Since the temperature sensor 53 is disposed on the part of the latent heat storage material 61 at the center of the casing 62 (the center of gravity of the latent heat storage material 61) and detects the temperature T_{A} of the latent heat storage material 61, it is possible to monitor whether a part of the latent heat storage material 61 is remaining in the solid state.

In particular, in an embodiment in which the plurality of switching elements 33 to 38 are arranged at intervals along the periphery of the first main surface 54 of the substrate 51 (the periphery of the radiator 52) in plan view, the temperature sensor 53 is easily positioned. That is, in such an embodiment, by only arranging the temperature sensor 53 at the center of the casing 62 (the center of gravity of the latent heat storage material 61), the temperature sensor 53 can be located away from the switching elements 33 to 38. Accordingly, compared with an embodiment in which the plurality of switching elements 33 to 38 are irregularly arranged, the temperature sensor 53 can easily be positioned.

A part of the latent heat storage material 61 that does not easily transition to the liquid state (that is, a region that is not easily heated) may be determined from an experiment in advance, and the temperature sensor 53 may be disposed on the part. The temperature T_{A} of the latent heat storage material 61 detected by the temperature sensor 53 is output to the microcomputer 25 (more specifically, a limiter control unit 83 that will be described below). Referring again to FIG. 2, the microcomputer 25 includes a central processing unit (CPU) and memories (a read-only memory (ROM), a random access memory (RAM), a non-volatile memory, and the like), and executes predetermined programs to serve as a plurality of function processing units.

The plurality of function processing units include an assist current value setting unit 81, a limiter 82, the limiter control unit 83, a current command value setting unit 84, a current deviation calculating unit 85, a proportional-integral (PI) control unit 86, a two-phase to three-phase converting unit 87, a pulse width modulation (PWM) control unit 88, a phase current calculating unit 89, a three-phase to two-phase converting unit 90, and a rotation angle calculating unit 91. The limiter 82 and the limiter control unit 83 serve as a supercooling suppressing unit that suppresses supercooling of the latent heat storage material 61. Supercooling is a phenomenon in which, in the case where the temperature T_{A} of the latent heat storage material 61 is in the liquid phase region 73, even when the temperature T_{A} of the latent heat storage material 61 is lowered below the freezing point T_{F}, the latent heat storage material 61 is not recrystallized and is maintained in the liquid state although the temperature T_{A} is supposed to be located in the solid phase region 71.

The assist current value setting unit 81 sets an assist current value Iₐ₀^{*} based on a steering torque T detected by the torque sensor 12 and a vehicle speed V detected by the vehicle speed sensor 23, and outputs the assist current value Iₐ₀^{*} to the limiter 82 at a predetermined constant current control cycle ΔT. The assist current value Iₐ₀^{*} corresponds to a motor current for driving the electric motor 18. That is, the assist current value Iₐ₀^{*} is set to a positive value when the electric motor 18 needs to generate a steering assist force for steering to the right, and is set to a negative value when the electric motor 18 needs to generate a steering assist force for steering to the left. The assist current value Iₐ₀^{*} is positive when the steering torque T has a positive value, and negative when the steering torque T has a negative value.

The assist current value Iₐ₀^{*} is set such that its absolute value increases as the absolute value of the steering torque T increases. The assist current value Iₐ₀^{*} is set such that its absolute value decreases as the vehicle speed V detected by the vehicle speed sensor 23 increases. A dead zone may be provided in which the assist current value Iₐ₀^{*} is set to zero when the absolute value of the steering torque T is a very small value less than or equal to a predetermined value.

The limiter 82 is switched between an operating state and a non-operating state. Under normal conditions, the limiter 82 is controlled in the non-operating state. When the limiter 82 is in the operating state, the limiter 82 limits the assist current value Iₐ₀^{*} to an assist current limit value Iₐ₁^{*}. The limiter 82 may limit the assist current value Iₐ₀^{*} to a value between a predetermined upper limit (positive value) and a predetermined lower limit (negative value).

On the other hand, when the limiter 82 is in the non-operating state, the limiter 82 simply outputs the assist current value Iₐ₀^{*} set by the assist current value setting unit 81 to the current command value setting unit 84. The limiter control unit 83 switches the limiter 82 between the operating state and the non-operating state, based on the assist current value Iₐ₀^{*} set by the assist current value setting unit 81 and the temperature T_{A} of the latent heat storage material 61 detected by the temperature sensor 53. The operations of the limiter control unit 83 will be described in detail below.

The current command value setting unit 84 sets the value of a current to be applied to the coordinate axes of a dq coordinate system as a current command value, based on the assist current value Iₐ₀^{*} or the assist current limit value Iₐ₁^{*}, and outputs the current command value to the current deviation calculating unit 85. More specifically, the current command value setting unit 84 generates a d-axis current command value I_{d}^{*} and a q-axis current command value I_{q}^{*} (hereinafter may be collectively referred to as "two-phase current command values I_{dq}^{*}").

More specifically, the current command value setting unit 84 sets the q-axis current command value I_{q}^{*} to a significant value, and sets the d-axis current command value I_{d}^{*} to zero. The two-phase current command values I_{dq}^{*} set by the current command value setting unit 84 are output to the current deviation calculating unit 85. The rotation angle calculating unit 91 calculates the rotation angle (electrical angle) of the rotor of the electric motor 18, based on the output signal of the rotation angle sensor 20, and outputs the rotation angle to the two-phase to three-phase converting unit 87 and the three-phase to two-phase converting unit 90.

The phase current calculating unit 89 calculates a U-phase current Iu, a V-phase current Iᵥ, and a W-phase current I_{w} (hereinafter may be collectively referred to as "three-phase detection currents I_{UVW}"), based on the phase currents of the two phases detected by the U-phase current sensor 45 and the W-phase current sensor 46, and outputs the three-phase detection currents I_{UVW} to the three-phase to two-phase converting unit 90. The three-phase to two-phase converting unit 90 converts the three-phase detection currents I_{UVW} in the UVW coordinate system calculated by the phase current calculating unit 89 into a d-axis detection current I_{d} and a q-axis detection current I_{q} (hereinafter may be collectively referred to as "two-phase detection currents I_{dq}") in the dq coordinate system, and outputs the two-phase detection currents I_{dq} to the current deviation calculating unit 85. For the coordinate transformation, the rotor angle θ calculated by the rotation angle calculating unit 91 is used.

The current deviation calculating unit 85 calculates deviations between the two-phase current command values I_{dq}^{*} set by the current command value setting unit 84 and the two-phase detection currents I_{dq} output from the three-phase to two-phase converting unit 90. More specifically, the current deviation calculating unit 85 calculates a deviation of the d-axis detection current I_{d} from the d-axis current command value I_{d}^{*}, and a deviation of the q-axis detection current I_{q} from the q-axis current command value I_{q}^{*}. These deviations are output to the PI control unit 86.

The PI control unit 86 executes a PI calculation on the current deviation calculated by the current deviation calculating unit 85, and thereby generates a d-axis voltage command value V_{d}^{*} and a q-axis voltage command value V_{q}^{*} (hereinafter may be collectively referred to as "two-phase voltage command values V_{dq}^{*}") to be applied to the electric motor 18. The two-phase voltage command values V_{dq}^{*} are output to the two-phase to three-phase converting unit 87. The two-phase to three-phase converting unit 87 converts the two-phase voltage command values V_{dq}^{*} to three-phase voltage command values V_{UVW}^{*}. For the coordinate transformation, the rotor angle θ calculated by the rotation angle calculating unit 91 is used.

The three-phase voltage command values V_{UVW}^{*} include a U-phase voltage command value V_{U}^{*}, a V-phase voltage command value V_{V}^{*}, and a W-phase voltage command value V_{W}^{*}. The three-phase voltage command values V_{UVW}^{*} are output to the PWM control unit 88. The PWM control unit 88 generates a U-phase PWM control signal, a V-phase PWM control signal, and a W-phase PWM control signal respectively having duty ratios corresponding to the U-phase voltage command value V_{U}^{*}, the V-phase voltage command value V_{V}^{*}, and the W-phase voltage command value W_{W}^{*}.

The PWM control unit 88 generates gate control signals for the respective switching elements 33 to 38 in the inverter device 1, based on these PWM control signals, and supplies the gate control signals to the gate drive circuits (not illustrated) connected to the gates of the respective switching elements 33 to 38. The gate drive circuits generate gate signals corresponding to the gate control signals supplied from the PWM control unit 88, and supplies the gate signals to the gates of the corresponding switching elements 33 to 38. Thus, voltages corresponding to the three-phase voltage command values V_{UVW}^{*} are applied to the field windings of the respective phases of the electric motor 18.

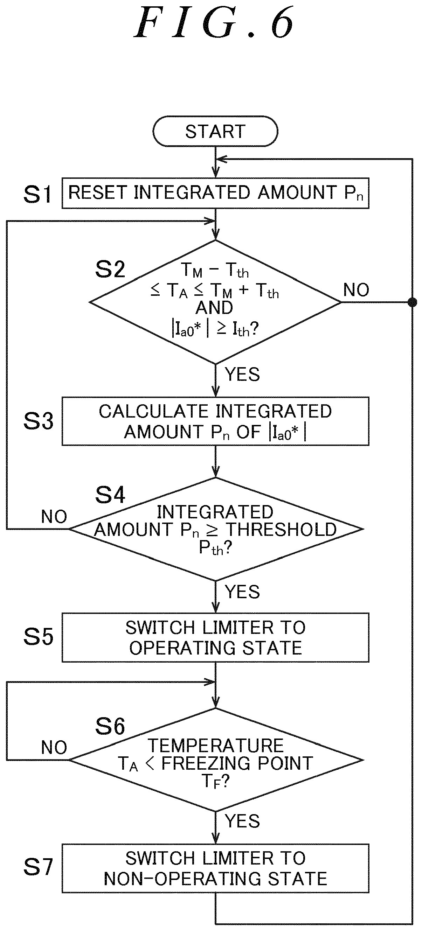

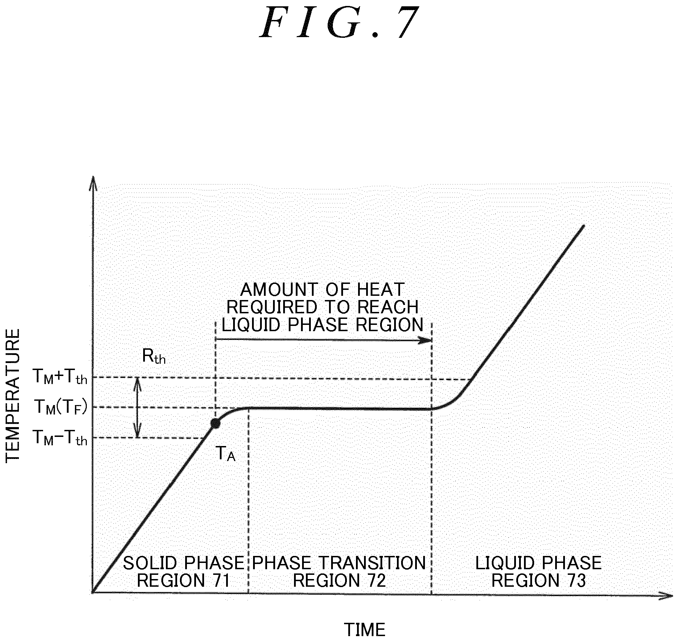

The current deviation calculating unit 85 and the PI control unit 86 serve as a current feedback control unit. The motor current flowing to the electric motor 18 is controlled by the current feedback control unit so as to approach the two-phase current command values I_{dq}^{*} set by the current command value setting unit 84. FIG. 6 is a flowchart illustrating exemplary operations of the limiter control unit 83. FIG. 7 is a graph illustrating the properties of the latent heat storage material 61.

Referring to FIG. 6, the limiter control unit 83 resets an integrated amount Pₙ of the assist current value Iₐ₀^{*} (described below) to set the operation state back to the initial state (step S1). Then, the limiter control unit 83 determines whether the following condition is satisfied: the temperature T_{A} of the latent heat storage material 61 is close to the melting point T_{M} of the latent heat storage material 61, and the temperature T_{A} of the latent heat storage material 61 is on a rising trend (step S2).

Referring to FIG. 7, the limiter control unit 83 may determine that the temperature T_{A} of the latent heat storage material 61 is close to the melting point T_{M} when the temperature T_{A} of the latent heat storage material 61 is in a threshold temperature range Rₜₕ that is determined in advance with reference to the melting point T_{M} of the latent heat storage material 61. The threshold temperature range Rₜₕ may have a value T_{M} - Tₜₕ obtained by subtracting a threshold temperature Tₜₕ (first threshold temperature) from the melting point T_{M} as the lower limit, and may have a value T_{M} + Tₜₕ obtained by adding a predetermined threshold temperature Tₜₕ (second threshold temperature) to the melting point T_{M} as the upper limit.

In this case, when the temperature T_{A} of the latent heat storage material 61 is in the range greater than or equal to the lower limit T_{M} - Tₜₕ and less than or equal to the upper limit T_{M} + Tₜₕ (T_{M} - Tₜₕ ≤ T_{A} ≤ T_{M} + Tₜₕ), the limiter control unit 83 determines that the temperature T_{A} of the latent heat storage material 61 is close to the melting point T_{M}. The threshold temperature Tₜₕ in the lower limit T_{M} - Tₜₕ and the threshold temperature Tₜₕ in the upper limit T_{M} + Tₜₕ may be different values.

The threshold temperature range Rₜₕ may have the melting point T_{M} as the upper limit. In this case, when the temperature T_{A} of the latent heat storage material 61 is in the range greater than or equal to the lower limit T_{M} - Tₜₕ and less than the melting point T_{M} (T_{M} - Tₜₕ ≤ T_{A} < T_{M}), the limiter control unit 83 determines that the temperature T_{A} of the latent heat storage material 61 is close to the melting point T_{M}. Referring again to FIG. 6, when the absolute value |Iₐo^{*}1| of the assist current value Iₐ₀^{*} is greater than or equal to a predetermined threshold Iₜₕ (Iₜₕ ≤ |Iₐo^{*}|), the limiter control unit 83 determines that the temperature T_{A} of the latent heat storage material 61 is on a rising trend.

If the limiter control unit 83 determines that the temperature T_{A} of the latent heat storage material 61 is less than the lower limit T_{M} - Tₜₕ of the threshold temperature range Rₜₕ (T_{M} - Tₜₕ > T_{A}), or determines that the absolute value |Iₐ₀^{*}| is less than the threshold Iₜₕ (Iₜₕ > |Iₐ₀^{*}|) (step S2: NO), the limiter control unit 83 resets the integrated amount Pₙ of the assist current value Iₐ₀^{*} (described below) (step S1), and executes step S2 again.

If the limiter control unit 83 determines that the temperature T_{A} of the latent heat storage material 61 is in the threshold temperature range Rₜₕ (T_{M} - Tₜₕ ≤ T_{A} ≤ T_{M} + Tₜₕ), and the absolute value |Iₐ₀^{*}| is greater than or equal to the threshold Iₜₕ (|Iₐ₀^{*}|≥ Itₕ) (step S2: YES), the limiter control unit 83 determines whether the amount of heat required to reach the liquid phase region 73 is applied from the switching elements 33 to 38 to the latent heat storage material 61 (steps S3 and S4).

In step S3, the limiter control unit 83 calculates the integrated amount Pₙ of the assist current value Iₐ₀^{*} during the period from the resetting of the integrated amount Pₙ to the present time. More specifically, this period is the period from the last resetting of the integrated amount Pₙ to the time when the procedure reaches step S3 without the determination in step S2 being negative. This period includes n current control cycles ΔT (n is a natural number), and n assist current values Iₐ₀^{*} corresponding to the periods. Accordingly, the limiter control unit 83 calculates the integrated amount Pₙ of n assist current values Iₐ₀ₙ^{*}.

More specifically, the integrated amount Pₙ is the sum obtained by integrating each multiplied value |Iₐ₀ₙ^{*}|× ΔT that is obtained by multiplying the absolute value |Iₐ₀ₙ^{*}| of each of n assist current values Iₐ₀ₙ^{*} by the current control cycle ΔT. That is, the integrated amount Pn is Pₙ - ₁ + |Iₐ₀ₙ^{*}| × ΔT. When n = 1, Pn - ₁ is zero, and the integrated amount Pₙ is |Iₐ₀₁^{*}| × ΔT. Then, the limiter control unit 83 determines whether the integrated amount Pₙ is greater than or equal to a predetermined threshold Pₜₕ (Pₙ ≥ Pₜₕ) (step S4). The threshold Pₜₕ may be a design parameter corresponding to the heat capacity of the latent heat storage material 61 stored in the radiator 52, and proportional to the mass.

When the integrated amount Pₙ is greater than or equal to Pₜₕ (Pₙ ≥ Pₜₕ), it means that the amount of heat required to reach the liquid phase region 73 is applied to the latent heat storage material 61. On the other hand, when the integrated amount Pₙ is less than Pₜₕ (Pₙ < Pₜₕ), it means that the amount of heat required to reach the liquid phase region 73 is not applied to the latent heat storage material 61. If the limiter control unit 83 determines that the integrated amount Pₙ is less than Pₜₕ (Pₙ < Pₜₕ) and the amount of heat required to reach the liquid phase region 73 is not applied to the latent heat storage material 61 (step S4: NO), the limiter control unit 83 executes step S2, step S3, and step S4 again.

In this manner, the limiter control unit 83 repeats step S2, step S3, and step S4 until the integrated amount Pₙ becomes greater than or equal to the threshold value Pₜₕ (Pₙ ≥ Pₜₕ). Then, the limiter control unit 83 calculates the integrated amount Pₙ of the assist current value Iₐ₀^{*} during the period in which the determination in step S2 continues to be affirmative without being negative after the resetting of the integrated amount Pₙ. If the limiter control unit 83 determines that the integrated amount Pₙ is greater than or equal to Pₜₕ (Pₙ ≥ Pₜₕ), and the amount of heat required to reach the liquid phase region 73 is applied to the latent heat storage material 61 (step S4: YES), the limiter control unit 83 switches the limiter 82 from the non-operating state to the operating state (step S5). Thus, the assist current value Iₐ₀^{*} output from the assist current value setting unit 81 is limited to the assist current limit value Iₐ₁^{*}.

Then, gate control signals generated based on the assist current limit value Iₐ₁^{*} are output from the PWM control unit 88 to the motor drive circuit unit 26. Thus, the amount of heat applied from the switching elements 33 to 38 to the latent heat storage material 61 decreases, so that the temperature T_{A} of latent heat storage material 61 drops. Note that the absolute value |Iₐ₁^{*}| of the assist current limit value Iₐ₁^{*} may be set to be less than the threshold Iₜₕ (Iₜₕ > |Iₐ₁^{*}|). In this case, the temperature T_{A} of the latent heat storage material 61 shifts to a falling trend, so that the temperature T_{A} of the latent heat storage material 61 can be reliably lowered.

The absolute value |Iₐ₁^{*}| of the assist current limit value Iₐ₁^{*} may be set based on a subtracted value Pₙ - Pₜₕ obtained by subtracting the threshold Pₜₕ from the integrated amount Pₙ. For example, the absolute value |Iₐ₁^{*}| of the assist current limit value Iₐ₁^{*} may be set to be a value proportional to the subtracted value Pₙ - Pₜₕ. Even in this case, the temperature T_{A} of the latent heat storage material 61 can be reliably lowered.

Subsequently, the limiter control unit 83 determines whether the temperature T_{A} of the latent heat storage material 61 is sufficiently lowered (step S6). In step S6, the limiter control unit 83 may determine whether the temperature T_{A} of the latent heat storage material 61 is less than the freezing point T_{F} of the latent heat storage material 61 (T_{A} < T_{F}). If the limiter control unit 83 determines that the temperature T_{A} is greater than or equal to the freezing point T_{F} (T_{A} ≥ T_{F}) (step S6: NO), the limiter control unit 83 executes step S6 again.

If the limiter control unit 83 determines that the temperature T_{A} is less than the freezing point T_{F} (T_{A} < T_{F}) (step S6: YES), the limiter control unit 83 switches the limiter 82 from the operating state to the non-operating state (step S7). Thus, the assist current value Iₐ₀^{*} output from the assist current value setting unit 81 is output unchanged to the current command value setting unit 84. Then, the limiter control unit 83 resets the integrated amount Pₙ of the assist current value Iₐ₀^{*} (step S1), and executes step S2 again.

In step S6, the limiter control unit 83 may determine whether the temperature T_{A} of the latent heat storage material 61 is less than the lower limit T_{M} - Tₜₕ of the threshold temperature range Rₜₕ (T_{A} < T_{M} - Tₜₕ). That is, if the limiter control unit 83 determines that the temperature T_{A} is greater than or equal to the lower limit T_{M} - Tₜₕ of the threshold temperature range Rₜₕ (T_{A} ≥ T_{M} - Tₜₕ) (step S6: NO), the limiter control unit 83 executes step S6 again.

If the limiter control unit 83 determines that the temperature T_{A} is less than the lower limit T_{M} - Tₜₕ of the threshold temperature range Rₜₕ (T_{A} < T_{M} - Tₜₕ) (step S6: YES), the limiter control unit 83 switches the limiter 82 from the operating state to the non-operating state (step S7). In this manner, in the inverter device 1, if the limiter control unit 83 determines that the temperature T_{A} of the latent heat storage material 61 reaches the liquid phase region 73, the limiter control unit 83 limits the assist current value Iₐ₀^{*} to prevent the temperature T_{A} from reaching the liquid phase region 73, thereby reducing the amount of heat to be applied to the latent heat storage material 61.

Thus, it is possible to suppress a rise in the temperature T_{A} of the latent heat storage material 61, and lower the temperature T_{A} of the latent heat storage material 61. Therefore, the temperature T_{A} of the latent heat storage material 61 can be prevented from reaching the liquid phase region 73. Further, the temperature T_{A} of the latent heat storage material 61 can be maintained in the solid phase region 71 or the phase transition region 72, so that a part of the latent heat storage material 61 can always be maintained in the solid state.

As a result, when the temperature T_{A} of the latent heat storage material 61 in the phase transition region 72 drops, the liquid part of the latent heat storage material 61 can be recrystallized, using the solid part of the latent heat storage material 61 as the starting point of recrystallization. This makes it possible to suppress supercooling of the latent heat storage material 61, and appropriately control the temperature of the switching elements 33 to 38.

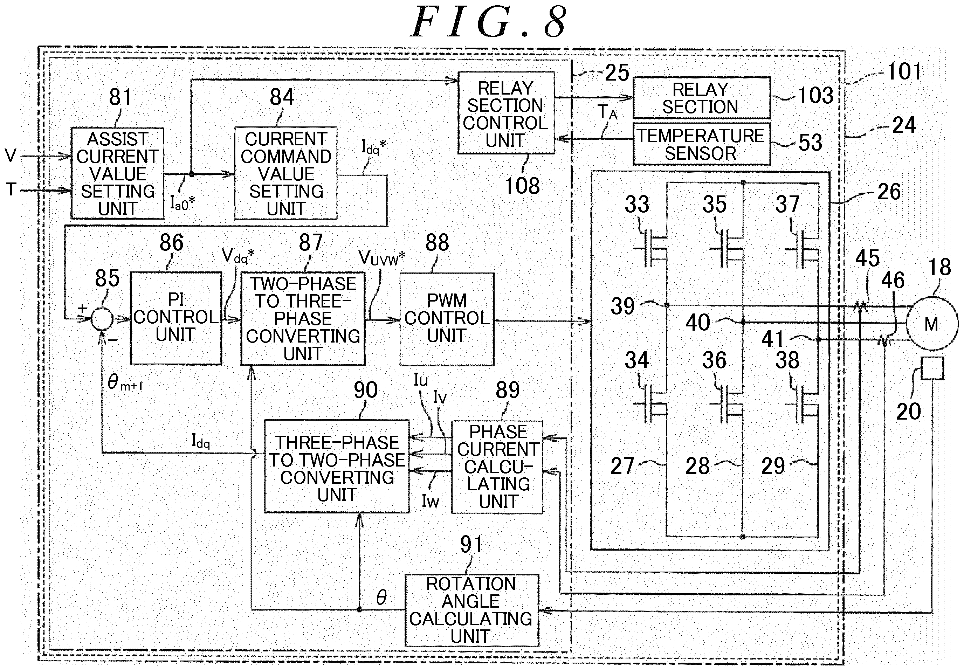

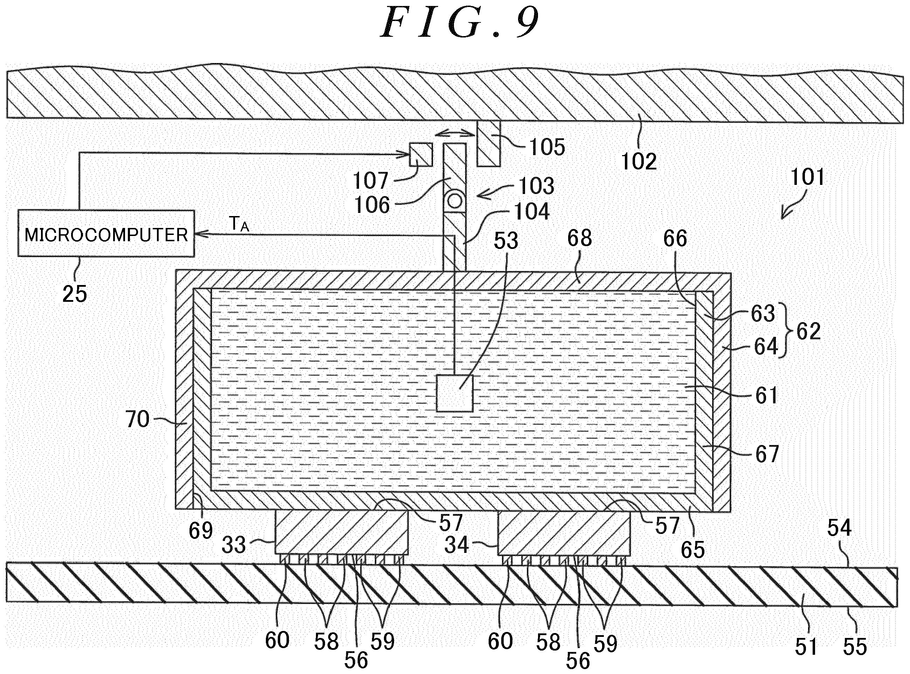

FIG. 8 is a block diagram schematically illustrating the electrical configuration of an ECU 24 to which an inverter device 101 according to a second embodiment of the present invention is applied. FIG. 9 is a cross-sectional view of a part corresponding to the part illustrated in FIG. 4, illustrating the general configuration of the inverter device 101 of FIG. 8. Elements corresponding to those of the inverter device 1 described above are denoted by the same reference numerals, and will not be further described.

Referring to FIGS. 8 and 9, the ECU 24 includes the inverter device 101 in place of the inverter device 1. The inverter device 101 differs in configuration from the inverter device 1. That is, the inverter device 101 does not include the limiter 82 or the limiter control unit 83, but includes a second radiator 102, a relay section 103, and a relay section control unit 108. The second radiator 102 is disposed away from the radiator 52. In this embodiment, the second radiator 102 is located at a position facing the substrate 51 with the radiator 52 interposed therebetween. A housing (not illustrated) made of metal (for example, made of aluminum) and accommodating the ECU 24 may be used as the second radiator 102.

The relay section 103 is a transfer member that transfers the heat of the radiator 52 to the second radiator 102. The relay section 103 is switched between a connecting state for thermally connecting the radiator 52 to the second radiator 102 and a disconnecting state for thermally disconnecting the radiator 52 from the second radiator 102. In the following description, it is assumed that the relay section 103 includes a mechanical relay. The relay section 103 includes a support part 104, a connection part 105, a movable part 106, and an electromagnetic part 107. Each of the support part 104, the connection part 105, and the movable part 106 may be made of a metal material.

The support part 104 is attached to the casing 62 of the radiator 52 (the lid part 64 in this embodiment). The connection part 105 is attached to the second radiator 102. The movable part 106 is pivotally attached to the support part 104. The movable part 106 pivots in a range between the connecting state and the disconnecting state. In the connecting state, the movable part 106 abuts the connection part 105 to thermally connect the radiator 52 to the second radiator 102. In the disconnecting state, the movable part 106 is spaced apart from the connection part 105 to thermally disconnect the radiator 52 from the second radiator 102.

The movable part 106 is normally in the disconnecting state. The movable part 106 may be normally in the connecting state. However, in this case, consideration needs to be given on the temperature rise of the second radiator 102 and the influence of the temperature rise on other members. For example, if the housing accommodating the ECU 24 is used as the second radiator 102, the temperature of the entire ECU 24 rises. Therefore, it is not always preferable that the movable part 106 is normally in the connecting state.

The electromagnetic part 107 is connected to the microcomputer 25. The electromagnetic part 107 has magnetic properties such that the electromagnetic part 107 is magnetized to N pole or S pole in accordance with the direction of the current input from the microcomputer 25, and generates an attractive force or a repulsive force to the movable part 106. When the electromagnetic part 107 generates a repulsive force, the movable part 106 is switched from the disconnecting state to the connecting state. Thus, the radiator 52 is thermally connected to the second radiator 102. Then, the heat of the radiator 52 is transferred to the second radiator 102 via the relay section 103, so that the temperature T_{A} of the latent heat storage material 61 is lowered.

On the other hand, when the electromagnetic part 107 generates an attractive force, the movable part 106 is switched from the connecting state to the disconnecting state. Thus, the second radiator 102 is thermally disconnected from the radiator 52, and is cooled naturally. Referring back to FIG. 8, in this embodiment, the plurality of function processing units of the microcomputer 25 include the relay section control unit 108, in place of the limiter 82 and the limiter control unit 83. In this embodiment, the relay section 103 and the relay section control unit 108 serve as a supercooling suppressing unit that suppresses supercooling of the latent heat storage material 61.

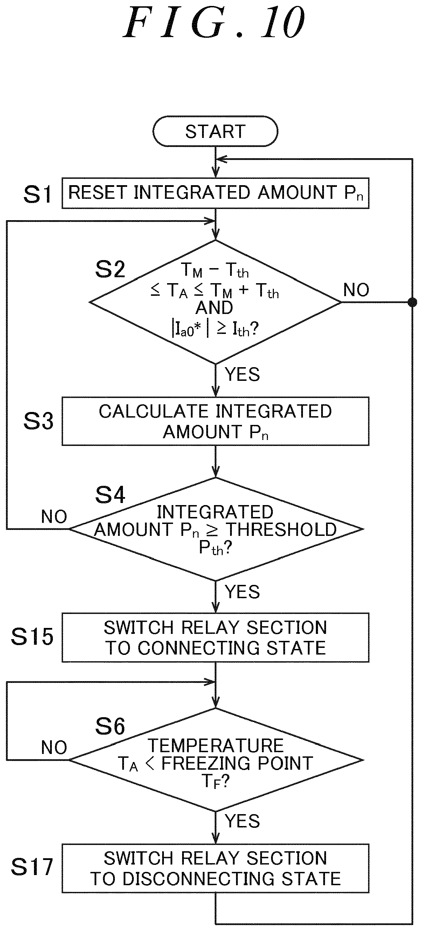

The relay section control unit 108 switches the relay section 103 between the disconnecting state and the connecting state, based on the assist current value Iₐ₀^{*} set by the assist current value setting unit 81 and the temperature T_{A} of the latent heat storage material 61 detected by the temperature sensor 53. FIG. 10 is a flowchart illustrating exemplary operations of the relay section control unit 108. The operations of the relay section control unit 108 differ from the operations of the limiter control unit 83 in that step S15 is executed in place of step S5, and in that step S17 is executed in place of step S7.

The operations of the relay section control unit 108 in steps other than steps S15 and S17 are the same as those of the limiter control unit 83 in steps other than steps S5 and S7, and will not be described herein. If the relay section control unit 108 determines that the integrated amount Pₙ is greater than or equal to Pₜₕ (Pₙ ≥ Pₜₕ), and the amount of heat required to reach the liquid phase region 73 is applied to the latent heat storage material 61 (step S4: YES), the relay section control unit 108 switches the relay section 103 from the disconnecting state to the connecting state (step S15).

Thus, the radiator 52 is thermally connected to the second radiator 102. Then, the heat of the radiator 52 is transferred to the second radiator 102 via the relay section 103, so that the temperature T_{A} of the latent heat storage material 61 is lowered. Then, if the relay section control unit 108 determines that the temperature T_{A} of the latent heat storage material 61 is less than the freezing point T_{F} (T_{A} < T_{F}) (step S6: YES), the relay section control unit 108 switches the relay section 103 from the connecting state to the disconnecting state (step S17). Thus, the second radiator 102 is thermally disconnected from the radiator 52, and is cooled naturally.

In this manner, in the inverter device 101, if the relay section control unit 108 determines that the temperature T_{A} of the latent heat storage material 61 reaches the liquid phase region 73, the relay section control unit 108 switches the relay section 103 from the disconnecting state to the connecting state to prevent the temperature T_{A} from reaching the liquid phase region 73, thereby transferring the heat of the radiator 52 to the second radiator 102. Thus, it is possible to suppress a rise in the temperature T_{A} of the latent heat storage material 61, and lower the temperature T_{A} of the latent heat storage material 61. Therefore, the temperature T_{A} of the latent heat storage material 61 can be prevented from reaching the liquid phase region 73. Further, the temperature T_{A} of the latent heat storage material 61 can be maintained in the solid phase region 71 or the phase transition region 72. Accordingly, a part of the latent heat storage material 61 can always be maintained in the solid state.

As a result, when the temperature T_{A} of the latent heat storage material 61 in the phase transition region 72 drops, the liquid part of the latent heat storage material 61 can be recrystallized, using the solid part of the latent heat storage material 61 as a starting point of recrystallization. This makes it possible to suppress supercooling of the latent heat storage material 61, and appropriately control the temperature of the switching elements 33 to 38.

While exemplary embodiments of the present invention are described above, the present invention may be practiced in other embodiments. In the first embodiment described above, if the limiter control unit 83 determines that the temperature T_{A} of the latent heat storage material 61 is in the threshold temperature range Rₜₕ (T_{M} - Tₜₕ ≤ T_{A} ≤ T_{M} + Tₜₕ), and the absolute value |Iₐ₀^{*}| is greater than or equal to the threshold Iₜₕ (|Iₐ₀^{*}| ≥ Itₕ) (step S2: YES), the limiter control unit 83 may skip steps S3 and S4, and switch the limiter 82 from the non-operating state to the operating state (step S5).

In the second embodiment described above, if the relay section control unit 108 determines that the temperature T_{A} of the latent heat storage material 61 is in the threshold temperature range Rₜₕ (T_{M} - Tₜₕ ≤ T_{A} ≤ T_{M} + Tₜₕ), and the absolute value |Iₐ₀^{*}| is greater than or equal to the threshold Iₜₕ (|Iₐ₀^{*}| ≥ Itₕ) (step S2: YES), the relay section control unit 108 may skip steps S3 and S4, and switch the relay section 103 from the disconnecting state to the connecting state (step S15).

An inverter device having a structure achieved by combining the first embodiment and the second embodiment may be employed. That is, the inverter device 1 of the first embodiment may further include the second radiator 102, the relay section 103, and the relay section control unit 108. The inverter device 101 of the second embodiment may further include the limiter 82 and the limiter control unit 83.

In the case of these structures, step S5 of the limiter control unit 83 and step S15 of the relay section control unit 108 may be performed in parallel. Also, step S7 of the limiter control unit 83 and step S17 of the relay section control unit 108 may be performed in parallel. In the embodiments described above, when the temperature T_{A} of the latent heat storage material 61 is in the range greater than or equal to the lower limit T_{M} - Tₜₕ and less than or equal to the upper limit T_{M} + Tₜₕ (T_{M} - Tₜₕ ≤ T_{A} ≤ T_{M} + Tₜₕ), the temperature T_{A} of the latent heat storage material 61 is determined to be close to the melting point T_{M}.

However, when an absolute value |T_{A} - T_{M}| of the deviation between the temperature T_{A} of the latent heat storage material 61 and the melting point T_{M} of the latent heat storage material 61 is less than or equal to the threshold temperature Tₜₕ (|T_{A} - T_{M}| ≤ Tₜₕ), the temperature T_{A} of the latent heat storage material 61 may be determined to be close to the melting point T_{M}. In the embodiments described above, each of the switching elements 33 to 38 may be a so-called vertical semiconductor device with an electrode formed also on the non-mounting surface 57. In this case, the radiator 52 is connected to the switching elements 33 to 38 in a manner insulated from the switching elements 33 to 38.

In the embodiments described above, the switching elements 33 to 38 may be devices other than MISFETs. Examples of devices other than MISFETs include high electron mobility transistor (HEMT), insulated gate bipolar transistor (IGBT), and bipolar junction transistor (BJT). Further, various modifications can be made to the present invention within the scope of the appended claims.

## Claims

1. An inverter device comprising:
a motor drive circuit unit that includes a plurality of arm circuits each including a plurality of switching elements, and that converts a direct current (DC) signal supplied from a DC power supply into a motor current formed of an alternating current (AC) signal;
a radiator that includes a latent heat storage material transitioning between a solid phase region corresponding to a solid state, a phase transition region where the solid state and a liquid state co-exist, and a liquid phase region corresponding to the liquid state, in accordance with a temperature of the latent heat storage material, and that absorbs heat generated in the plurality of switching elements;
a temperature sensor that detects the temperature of the latent heat storage material; and
a control device connected to the plurality of switching elements and the temperature sensor;
wherein the control device includes
a determining unit that determines whether a condition is satisfied, the condition being that the temperature of the latent heat storage material is close to a melting point of the latent heat storage material, and that the temperature of the latent heat storage material is on a rising trend, and
a supercooling suppressing unit that limits the motor current when the determining unit determines that the condition is satisfied.

2. The inverter device according to claim 1, wherein:
the control device includes a calculating unit that calculates an integrated amount of the motor current during a period in which the determining unit continues to determine that the condition is satisfied; and
the supercooling suppressing unit determines whether the temperature of the latent heat storage material reaches the liquid phase region, based on the integrated amount of the motor current, and limits the motor current when the supercooling suppressing unit determines that the temperature of the latent heat storage material reaches the liquid phase region.

3. The inverter device according to claim 2, wherein the supercooling suppressing unit determines that the temperature of the latent heat storage material reaches the liquid phase region when the integrated amount of the motor current is greater than or equal to a predetermined threshold.

4. The inverter device according to any one of claims 1 to 3, wherein the supercooling suppressing unit removes a limit on the motor current when the temperature of the latent heat storage material drops below a freezing point of the latent heat storage material.

5. An inverter device comprising:
a motor drive circuit unit that includes a plurality of arm circuits each including a plurality of switching elements, and converts a DC signal supplied from a DC power supply into a motor current formed of an AC signal;
a first radiator that includes a latent heat storage material transitioning between a solid phase region corresponding to a solid state, a phase transition region where the solid state and a liquid state co-exist, and a liquid phase region corresponding to the liquid state, in accordance with a temperature of the latent heat storage material, and that absorbs heat generated in the plurality of switching elements;
a second radiator disposed away from the first radiator;
a switching unit switchable between a connecting state for thermally connecting the first radiator to the second radiator, and a disconnecting state for thermally disconnecting the first radiator from the second radiator;
a temperature sensor that detects the temperature of the latent heat storage material; and
a control device connected to the plurality of switching elements, the switching unit, and the temperature sensor;
wherein the control device includes
a determining unit that determines whether a condition is satisfied, the condition being that the temperature of the latent heat storage material is close to a melting point of the latent heat storage material, and that the temperature of the latent heat storage material is on a rising trend, and
a supercooling suppressing unit that switches the switching unit from the disconnecting state to the connecting state when the determining unit determines that the condition is satisfied.

6. The inverter device according to claim 5, wherein:
the control device includes a calculating unit that calculates an integrated amount of the motor current during a period in which the determining unit continues to determine that the condition is satisfied; and
the supercooling suppressing unit determines whether the temperature of the latent heat storage material reaches the liquid phase region, based on the integrated amount of the motor current, and switches the switching unit from the disconnecting state to the connecting state when the supercooling suppressing unit determines that the temperature of the latent heat storage material reaches the liquid phase region.

7. The inverter device according to claim 6, wherein the supercooling suppressing unit determines that the temperature of the latent heat storage material reaches the liquid phase region when the integrated amount of the motor current is greater than or equal to a predetermined threshold.

8. The inverter device according to any one of claims 5 to 7, wherein the supercooling suppressing unit switches the switching unit from the connecting state to the disconnecting state when the temperature of the latent heat storage material drops below a freezing point of the latent heat storage material.

9. The inverter device according to any one of claims 1 to 8, wherein the determining unit determines that the temperature of the latent heat storage material is close to the melting point of the latent heat storage material when the temperature of the latent heat storage material is in a threshold temperature range having a lower limit and an upper limit, the lower limit being a value obtained by subtracting a predetermined first threshold temperature from the melting point of the latent heat storage material, the upper limit being a value obtained by adding a predetermined second threshold temperature to the melting point of the latent heat storage material.

10. The inverter device according to any one of claims 1 to 9, wherein the determining unit determines that the temperature of the latent heat storage material is on a rising trend when an absolute value of the motor current is greater than or equal to a predetermined threshold.
